# EUROPEAN PATENT APPLICATION

(11) **EP 0 573 057 A1**
(43) Date of publication of application: **08.12.1993**
(21) Application number: 93109009.6
(22) Date of filing: 04.06.1993
(51) Int. Cl.: H01L 21/00

(54) **Integrated circuit structure processing apparatus with chemically corrosion-resistant Al2O3 protective coating on surface of quartz window exposed to corrosive chemicals**

(30) Priority: 05.06.1992 US 893869
(71) Applicant: APPLIED MATERIALS, INC., Santa Clara California 95052-8039 (US)
(72) Inventor: Chew, Sandy M., Fremont, California 94536 (US); Wong, Manus K., San Jose, California 95131 (US)
(74) Representative: Kahler, Kurt, Dipl.-Ing.

(57) **Abstract**

An improved integrated circuit processing apparatus is disclosed wherein a protective coating (40) of Al₂O₃ on the inner surface of a quartz (SiO₂) window (10) in the wall (24) of the integrated circuit processing apparatus provides an enhanced resistance to the corrosive effects of fluorine-containing reagents on the protected inner surface of the quartz window (10). Formation of an Al₂O₃ coating having a minimum thickness of about 4 µm, preferably about 6 µm, and most preferably about 8 µm, up to a maximum thickness of about 15 µm, preferably about 12 µm, with a coating uniformity of ± 15% of the average coating thickness provides the desired protection of the inner surface of the quartz window (10) from corrosive attack by fluorine-containing reagents such as NF₃, SF₆, and fluorine-containing hydrocarbons, e. g. C₂F₆.

## Description

### BACKGROUND OF THE INVENTION

### 1. Field of the Invention

This invention relates to processing apparatus for the fabricating of integrated circuit structures. More particularly, this invention relates to processing apparatus for the formation of integrated circuit structures having a quartz window therein formed with a protective coating on its inner surface to protect the window from corrosive attack of processing reagents used within the processing apparatus, particularly fluorine-containing gases.

### 2. Description of the Related Art

In apparatus for the processing of integrated circuit structures on semiconductor wafers, it is common to heat the wafer, during the manufacturing process of forming the integrated circuit structure thereon, in a processing chamber, such as a vacuum chamber, using infra-red heating sources external to the chamber. One or more optically transparent materials such as quartz windows are then provided in the walls of the chamber through which the heat rays from the external heating source penetrate into the chamber to heat the wafer.

It is also common to provide optically transparent windows in such chambers used for the formation of integrated circuit structures on semiconductor wafers to optically monitor the temperature of the wafer and/or other internal portions of the chamber using an optical pyrometer.

In either case, such windows are usually formed of quartz (SiO₂), because of its combined optical transparency and chemical resistance to attack by the reagents used in such processing apparatus. However, even quartz does not stand up well to the corrosive attack of fluorine-containing reagents, usually gases, which may be used in the processing of the semiconductor wafer. Such fluorine-containing reagents, such as NF₃; SF₆; and fluorinated hydrocarbon gases such as CF₄, CHF₃, CH₂F₂, CH₃F, C₂F₆, etc.; may be used in carrying out etching processes, while fluorine-containing gases such as WF₆ may be used for tungsten deposition, and other fluorine-containing gases such as the aforementioned NF₃ and C₂F₆ gases may be used as cleaning gases following deposition processes such as, for example, TEOS, nitride, or tungsten depositions.

When such quartz windows are regularly exposed to such fluorine-containing gases, the quartz window will last for from about 9000 to about 11,000 wafers, or about 3 months, before it must be replaced due, for example, to NF₃ corrosion. However, while such replacement may be due to loss of opacity of the window to transmit the heat from the external heating lamps, or due to the inability of the window to properly permit optical monitoring of the heat, particle generation due to such corrosive effects may occur much sooner. In fact, particles generated from corrosion of the quartz window by NF₃ can be observed after the processing of as few as 500 wafers in the chamber.

Such particle generation is highly undesirable in the processing of integrated circuit structures due to the detrimental effects of such particle generation on the yield of integrated circuit chips per wafer.

It would, therefore, be highly desirable to provide a chemically corrosion-resistant surface on such a quartz window in integrated circuit processing apparatus which would, in particular, be resistant to attack by fluorine-containing reagents which come in contact with the inner surface of the window.

### SUMMARY OF THE INVENTION

We have discovered that the provision of a protective coating of Al₂O₃ on the inner surface of a quartz (SiO₂) window in an integrated circuit processing apparatus provides an enhanced resistance to the corrosive effects of fluorine-containing reagents on the protected quartz window surface. Formation of an Al₂O₃ coating having a minimum thickness of about 4 µm (microns), preferably about 6 µm (microns), and most preferably about 8 µm (microns), up to a maximum thickness of about 15 µm (microns), preferably about 12 µm (microns), provides the desired protection of the inner surface of the quartz (SiO₂) window from corrosive attack by fluorine-containing reagents such as NF₃, SF₆, and fluorine-containing hydrocarbons, e.g., C₂F₆.

### BRIEF DESCRIPTION OF THE DRAWINGS

Figure 1 is a fragmentary view of a portion of an integrated circuit processing apparatus showing the quartz window with the protective coating shown formed on the inner surface thereof.

Figure 2 is a flow sheet illustrating formation of the quartz window with the protective coating thereon.

### DETAILED DESCRIPTION OF THE INVENTION

The invention comprises an improved apparatus for the processing of integrated circuit structures on semiconductor wafers wherein the inner surface of one or more quartz (SiO₂) windows in the processing chamber is provided with a corrosion-resistant protective coating of Al₂O₃ thereon which is particularly resistant to the corrosive effects of fluorine-containing reagents used in the processing chamber.

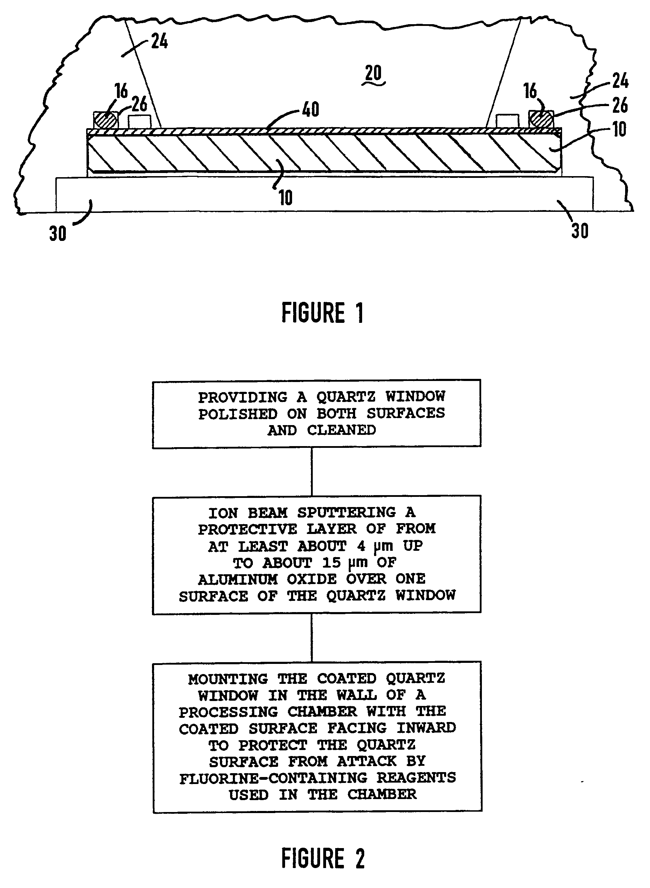

The improved integrated circuit structure processing apparatus of the invention is shown in Figure 1 wherein a quartz window 10 is shown sealed to a chamber wall 24 of an integrated circuit processing chamber 20 via an o-ring seal 16 carried in an annular groove 26 in wall 24. A heating lamp 30 is shown juxtaposed adjacent the outside surface of window 10.

A thin coating layer 40 of Al₂O₃ is shown formed on the inner surface of window 10 with the illustrated thickness of coating 40, relative to the thickness of window 10, shown exaggerated for illustrative purposes only, it being understood that the quartz window is much thicker (typically about 12.7 mm (0.5")) than the thin Al₂O₃ coating deposited thereon.

The thickness of protective Al₂O₃ coating film 40, however, must be sufficient to provide the desired protection of the underlying quartz window material from chemical attack from the reagents used within chamber 20. Protective Al₂O₃ coating film 40 should, therefore, have a minimum average thickness of at least about 4 µm (microns), preferably about 6 µm (microns), and most preferably about 8 µm (microns) to provide such protection.

The maximum thickness of protective Al₂O₃ coating film 40 will be governed both by process economics and coating stress. The economics of the deposition process dictate that an excessive amount of Al₂O₃ coating film not be used because of the slow deposition rate (of from about 0.2 to about 0.4 µm/hour) which is used to ensure deposition of a uniform and adherent coating film on the quartz window surface. From a mechanical standpoint, thicker coatings create both internal stress within the coating as well as thermal stress with respect to the SiO₂ window itself as the Al₂O₃ and the quartz window are heated to the operating temperature of the apparatus, which may, for example, range from about 200°C to about 700°C.

Therefore, the average maximum thickness of the deposited Al₂O₃ coating film on the quartz window should not exceed about 15 µm (microns) and preferably should not exceed about 12 µm (microns).

Furthermore, to ensure uniform protection of the quartz window, the coating thickness uniformity should be ± 15%. That is, the thickness of the coating film at any point on the quartz window should not be more than 15% thinner or thicker than the average thickness of the Al₂O₃ coating film.

To form a uniform and adherent Al₂O₃ coating film on the surface of the quartz window, the window surface is first optically polished on both sides, with the side to be coated free of any visible open bubbles and polished to a 40-20 or better polished surface, as defined in section 3.5 of Military Specification MIL-O-13830A.

After the polishing step, the polished quartz window is then cleaned using a 5 wt.% HF solution into which the polished quartz window is dipped for from about 10 to about 30 seconds. After such cleaning, the polished window is rinsed in deionized water and allowed to dry.

After cleaning and drying, the polished quartz window is placed in an ion beam deposition chamber and aluminum is sputtered from an aluminum target onto the 40-20 polished surface of the quartz window with an ion beam while maintaining an oxygen atmosphere in the chamber so that the sputtered aluminum is immediately oxidized to form the desired Al₂O₃ coating as it deposits on the quartz window. The ion beam sputter deposition process is carried out until the desired Al₂O₃ coating thickness is deposited.

The coated quartz window may then be removed from the deposition chamber and the deposited Al₂O₃ coating visually examined for pinholes. If none are found, the coated quartz window may be mounted in the wall of the integrated circuit processing apparatus, with the coated surface facing inwardly, where the Al₂O₃ coating will serve to protect the surface of the quartz window from corrosive attack by the chemical reagents, particularly fluorine-containing reagents, used in the processing of integrated circuit structures on semiconductor wafers.

To further illustrate the invention, a quartz window constructed in accordance with the invention with a 10 µm (microns) thick Al₂O₃ coating deposited on the inner surface thereof, was installed in the wall of a processing chamber used in the processing of integrated circuit structures. A silicon wafer was mounted on a susceptor in the chamber and a tungsten CVD deposition was carried out for 110-125 seconds at a temperature of about 475°C. The wafer was then removed from the chamber and the chamber was cleaned to remove tungsten deposits using an NF₃ plasma. The entire wafer insertion, deposition, removal, and cleaning cycle lasted about 5 minute. This process was repeated a number of times during which the Al₂O₃ coating on the quartz window was periodically inspected visually from outside the chamber for any evidence of corrosion. None was observed. Particle generation was also monitored periodically. Average particle count was around 3-4 per wafer, which is well below an acceptable limit.

After 10,000 cycles, representing the processing of 10,000 wafers in the chamber, the quartz window was found to have no visible signs of corrosion from the repeated exposure to the fluorine-containing chemicals in the processing chamber during the 10,000 cycles. Rather, the window looked the same as before the testing started.

Thus, the invention provides an improved apparatus for the processing of integrated circuit structures on semiconductor wafers comprising a quartz window having a protective coating of Al₂O₃ formed on the inner surface of the quartz window to protect the quartz surface from corrosive attack by the processing chemicals, particularly fluorine-containing reagents, used within the processing chamber.

## Claims

1. An apparatus for the processing of integrated circuit structures on semiconductor wafers,
**characterized** by
a protective coating (40) of Al₂O₃ formed on the inner surface of a quartz window (10) mounted in a wall (24) of said apparatus.

2. The apparatus of claim 1,
wherein said protective coating (40) of Al₂O₃ on said inner surface of said quartz window (10) has a minimum thickness of at least about 4 µm (microns).

3. The apparatus of claim 1,
wherein said protective coating (40) of Al₂O₃ on said inner surface of said quartz window (10) has a minimum thickness of at least about 6 µm (microns).

4. The apparatus of claim 1,
wherein said protective coating (40) of Al₂O₃ on said inner surface of said quartz window (10) has a minimum thickness of at least about 8 µm (microns).

5. The apparatus of claim 1,
wherein said protective coating (40) of Al₂O₃ on said inner surface of said quartz window (10) has a thickness ranging from at least about 4 µm (microns) up to about 15 µm (microns).

6. The apparatus of claim 1,
wherein said protective coating (40) of Al₂O₃ on said inner surface of said quartz window (10) has a thickness ranging from at least about 8 µm (microns) up to about 12 µm (microns).

7. The apparatus of claim 5 or 6,
wherein said protective coating (40) of Al₂O₃ on said inner surface of said quartz window (10) has a coating uniformity of ± 15% of the average coating thickness.

8. An apparatus for the processing of integrated circuit structures on semiconductor wafers wherein one or more optically transparent quartz windows (10) are mounted in the wall (24) of a processing chamber (20),
**characterized** by
a protective coating (40) of from about 4 to about 15 µm (microns) of Al₂O₃ formed on the inner surface of each of said one or more quartz windows (10) to protect said one or more quartz windows (10) from corrosive attack by fluorine-containing reagents used in said chamber (20).

9. The apparatus of claim 8,
wherein said protective coating (40) of Al₂O₃ on said inner surf ace of said one or more quartz windows (10) has a coating uniformity of ± 15% of the average coating thickness.

10. The apparatus of claim 8 or 9,
wherein said protective coating (40) of Al₂O₃ on said inner surface of said one or more quartz windows (10) has a thickness ranging from at least about 8 µm (microns) up to about 12 µm (microns).

11. An apparatus for the processing of integrated circuit structures on semiconductor wafers wherein one or more optically transparent quartz windows (10) are mounted in the wall (24) of a processing chamber (20) to permit external heating of a semiconductor wafer within said chamber (20) via one or more heat lamps (30) located external to said chamber (20) and adjacent to said windows (10),
**characterized** by
a protective coating of from about 8 to about 12 µm (microns) of Al₂O₃ formed on the inner surface of each of said one or more quartz windows (10) with a coating uniformity of ± 15% of the average coating thickness to protect said one or more quartz windows (10) from corrosive attack by fluorine-containing reagents used in said chamber (20).
